# EUROPÄISCHE PATENTANMELDUNG

(11) **EP 2 667 500 A1**
(43) Veröffentlichungstag der Anmeldung: **27.11.2013**
(21) Anmeldenummer: 12177109.1
(22) Anmeldetag: 19.07.2012
(51) Int. Cl.: H02M 3/335, H03F 3/217, H03F 3/38

(54) **Verstärkerschaltung und Verfahren zum Betrieb einer Verstärkerschaltung**

(30) Priorität: 22.05.2012 DE 102012208582
(71) Anmelder: Siemens Aktiengesellschaft, 80333 München (DE)
(72) Erfinder: Meng, Markus, 5420 Ehrendingen (CH); Waldmeier, Christoph, 8854 Siebenen (CH)

(57) **Zusammenfassung**

Die Erfindung betrifft eine Verstärkerschaltung (10) und ein Verfahren zum Betrieb einer Verstärkerschaltung (10), wobei die Verstärkerschaltung (10) Folgendes umfasst: Eine Eingangsschaltung (E) mit Mitteln (Q1, Q2, Q3, Q4) zum Zerhacken einer Betriebsspannung (V_{Bat}). Einen hochsetzenden Transformator (TR) mit einer Primärwicklung (P) und einer ersten und zweiten Sekundärwicklung (S1, S2), an dessen Primärwicklung (P) die zerhackte Betriebsspannung (V_{Bat}) anlegbar ist oder angelegt wird und an dessen Sekundärwicklungen (S1, S2) die hochgesetzte Betriebsspannung (V_{Bat}) abgreifbar ist oder abgegriffen wird. Eine Ausgangsschaltung (A) mit Mitteln (SW1, SW2, SW3, SW4) zur Rekonstruktion der zerhackten Betriebsspannung (V_{Bat}) und einen der Ausgangsschaltung (A) nachfolgenden Tiefpassfilter (L1, C1), an dem die rekonstruierte, hochgesetzte Betriebsspannung (V_{Bat}) als Ausgangssignal (V) abgreifbar ist oder abgegriffen wird.

## Beschreibung

Die Erfindung betrifft eine Verstärkerschaltung sowie ein Verfahren zum Betrieb einer solchen Verstärkerschaltung. Verstärkerschaltungen sind an sich bekannt. Eine im Audio-Bereich übliche Verstärkerschaltung ist unter der Bezeichnung Class-D bekannt. Aus der WO 030/90343 A2 ist eine Class-D Verstärkerschaltung mit einer Rückführung bekannt, wobei die Rückführung und damit das verstärkte Ausgangssignal sowohl die Verstärkung wie auch eine Arbeitsfrequenz beeinflusst.

Eine im hörbaren Bereich liegende Resonanzfrequenz eines Class-D Verstärkers beeinflusst maßgeblich die Qualität der Verstärkung. Eine Schwingfähigkeit ergibt sich ganz allgemein aufgrund der durch den als Ausgangsfilter fungierenden Tiefpassfilter bewirkten Phasenverschiebung und einer weiteren Phasenverschiebung durch weitere Bauteile der Verstärkerschaltung, die sich üblicherweise zu einer Phasenverschiebung von 180° summieren. Der Pulsweitenmodulator trägt eine weitere Phasenverschiebung von 180° bei, so dass sich eine gesamte Phasenverschiebung von 360° ergibt. Verstärkerschaltungen mit einer solchen Phasenverschiebung und einer Verstärkung größer als eins schwingen mit der jeweiligen Resonanzfrequenz. Dem Problem einer Resonanzfrequenz im hörbaren Bereich hat man dadurch zu begegnen versucht, dass eine Phasenverschiebung von 360° vermieden wird. Dies ist durch die Ergänzung der Verstärkerschaltung um Schaltelemente, die die Phasenlage des Signals beeinflussen (phase lead network / phase lag network), möglich.

Eine Aufgabe der Erfindung besteht darin, eine weitere Ausführungsform einer Verstärkerschaltung anzugeben.

Diese Aufgabe wird mit einer Verstärkerschaltung mit den Merkmalen des Anspruchs 1 gelöst. Dazu ist bei einer erfindungsgemäßen Verstärkerschaltung Folgendes vorgesehen: Die Verstärkerschaltung umfasst eine Eingangsschaltung, einen insbesondere hochsetzenden Transformator, eine Ausgangsschaltung und zumindest einen Filter, insbesondere in Form eines Tiefpassfilters. Der Transformator umfasst eine Primärwicklung und eine erste und zweite Sekundärwicklung. Die Eingangsschaltung und die Ausgangsschaltung sind dabei über den Transformator galvanisch entkoppelt verbunden, indem die Primärwicklung zur Eingangsschaltung und die Sekundärwicklungen zur Ausgangsschaltung gehören. Die Eingangsschaltung umfasst Mittel, insbesondere elektrisch ansteuerbare Schaltelemente, zum Zerhacken einer an die Verstärkerschaltung angelegten oder anlegbaren unipolaren Betriebsspannung (Gleichspannung). Die Mittel zum Zerhacken der Betriebsspannung sind mit pulsweitenmodulierten Ansteuersignalen ansteuerbar oder werden mit diesen Ansteuersignalen angesteuert, wobei sich die Pulsweitenmodulation der Ansteuersignale entsprechend einem zu verstärkenden Audiosignal ergibt. Die zerhackte und als Ergebnis des Zerhackens biploare Betriebsspannung ist an die Primärwicklung des Transformators anlegbar oder wird an die Primärwicklung des Transformators angelegt. An den Sekundärwicklungen des Transformators ist eine im Folgenden als Zwischenspannung bezeichnete hochgesetzte, biploare Spannung abgreifbar oder wird eine solche hochgesetzte, biploare Zwischenspannung abgegriffen. Die Zwischenspannung resultiert aus der zerhackten Betriebsspannung und bei einem hochsetzenden Transformator ergibt sich die Zwischenspannung als entsprechend dem Übertragungsverhältnis des Transformators hochgesetzte Zwischenspannung. Die Ausgangsschaltung umfasst Mittel, insbesondere elektrisch ansteuerbare Schaltelemente, zum phasenrichtigen Zusammensetzen der zunächst genau wie die zerhackte Betriebsspannung segmentierten, biploaren Zwischenspannung. Auch die Mittel zum Zusammensetzen der Zwischenspannung sind mit entsprechend dem zu verstärkenden Audiosignal pulsweitenmodulierten Ansteuersignalen ansteuerbar oder werden mit solchen Ansteuersignalen angesteuert. Im Ergebnis ist an dem der Ausgangsschaltung nachfolgenden Filter als Ausgangssignal eine entsprechend der Betriebsspannung und dem Übertragungsverhältnis des Transformators verstärkte Form des Audiosignals abgreifbar oder wird eine so verstärkte Form des Audiosignals abgegriffen.

Der Vorteil der Erfindung besteht darin, dass die Verstärkerschaltung die Stromversorgung sowie den Modulator und eine Class-D Endstufe vereint. Ein weiterer Vorteil besteht darin, dass als Transformator ein kleinvolumiger HF-Transformator eingesetzt werden kann, um NF-Signale bis hinunter zu einer Frequenz von Null Hertz (Gleichspannung) zu übertragen und zu verstärken. Mit der Verwendung eines Transformators zur Erzeugung einer hochgesetzten Zwischenspannung aus der Betriebsspannung kommt ein elektrisches Bauelement mit einem grundsätzlich sehr hohen Wirkungsgrad zum Einsatz. Dadurch, dass die Verstärkerschaltung die Betriebsspannung mit einer dafür vorgesehenen Eingangsschaltung hochfrequent zerhackt, reicht ein klein dimensionierter Transformator, insbesondere eine klein dimensionierte Primärwicklung aus, um Sättigungseffekte und dergleichen zu vermeiden und damit eine hohe Güte der Signalübertragung durch den Transformator zu gewährleisten.

Vorteilhafte Ausgestaltungen der Erfindung sind Gegenstand der Unteransprüche. Dabei verwendete Rückbeziehungen weisen auf die weitere Ausbildung des Gegenstandes des Hauptanspruches durch die Merkmale des jeweiligen Unteranspruches hin. Sie sind nicht als ein Verzicht auf die Erzielung eines selbständigen, gegenständlichen Schutzes für die Merkmalskombinationen der rückbezogenen Unteransprüche zu verstehen. Des Weiteren ist im Hinblick auf eine Auslegung der Ansprüche bei einer näheren Konkretisierung eines Merkmals in einem nachgeordneten Anspruch davon auszugehen, dass eine derartige Beschränkung in den jeweils vorangehenden Ansprüchen nicht vorhanden ist.

Bei einer Ausführungsform der Verstärkerschaltung besteht zwischen den pulsweitenmodulierten Ansteuersignalen zum Zerhacken der Betriebsspannung einerseits und den pulsweitenmodulierten Ansteuersignalen zum Zusammensetzen der Zwischenspannung andererseits eine durch das zu verstärkende Audiosignal bestimmte Phasenverschiebung. Diese Phasenverschiebung prägt der vor dem Filter in der Ausgangsschaltung erzeugten Zwischenspannung die Frequenz des zu verstärkenden Audiosignals ein, so dass am Ausgang des Filters das verstärkte Audiosignal abgreifbar ist.

Bei einer weiteren Ausführungsform der Verstärkerschaltung sind die Ansteuersignale aufgrund eines Ausgangssignals eines Komparators gebildet oder bildbar, wobei dem Komparator einerseits das zu verstärkende Audiosignal und andererseits das zurückgeführte Ausgangssignal zuführbar ist, wobei sich die Phasenverschiebung zwischen den Ansteuersignalen entsprechend einer jeweiligen Pulsbreite des am Ausgang des Komparators resultierenden pulsweitenmodulierten Signals als Ergebnis des Vergleichs von zurückgeführtem Ausgangssignal und zu verstärkendem Audiosignal ergibt.

Bei einer nochmals weiteren Ausführungsform der Verstärkerschaltung ist vorgesehen, dass die Eingangsschaltung als H-Brückenschaltung ausgeführt ist und als Mittel zum Zerhacken der Betriebsspannung vier elektrisch ansteuerbare Schaltelemente fungieren, die mit der an einen Mittelabgriff von je zwei in Serie geschalteten Schaltelementen angeschlossenen Primärwicklung des Transformators die H-Brücke bilden. Dadurch, dass sich die Primärwicklung des Transformators im Brückenzweig der H-Brücke befindet, kann durch eine Beeinflussung der Schaltstellung der Schaltelemente, bei denen es sich üblicherweise um elektronische Schaltelemente, zum Beispiel MOSFETs, handelt, das Zerhacken der Betriebsspannung bewirkt werden.

Bei einer besonderen Ausführungsform der Verstärkerschaltung mit einer solchen H-Brückenschaltung als Eingangsschaltung ist vorgesehen, dass die vier eingangsseitigen Schaltelemente hochfrequent und paarweise ansteuerbar sind oder angesteuert werden, wobei die paarweise Ansteuerung alternierend jeweils eines der jeweils zwei in Serie geschalteten Schaltelemente betrifft. Der Vorteil besteht darin, dass durch die paarweise und alternierende Ansteuerung der Schaltelemente die Spannung und der Strom im Brückenzweig in der Polarität verändert werden kann. Durch die alternierende Ansteuerung der Schaltelemente ergibt sich ein periodischer Wechsel der Polarität der Spannung im Brückenzweig und damit eine periodische Änderung des jeweils im Transformator resultierenden magnetischen Feldes und damit auch eine periodische Änderung der auf der Ausgangsseite des Transformators jeweils erzeugten Spannung des Ausgangssignals.

Wenn die Ansteuerschaltung einen ersten und einen zweiten von der Ansteuerschaltung angesteuerten Treiber umfasst, wobei der erste und zweite Treiber über eine galvanische Entkopplung mit einer treiberseitigen Primärspule und einer ersten und zweiten Sekundärspule zur antivalenten Ansteuerung eines ersten bzw. zweiten Schaltelements der jeweils zwei in Serie geschalteten Schaltelemente wirksam ist, stellt dies eine leicht und vergleichsweise unkompliziert zu realisierende Möglichkeit zum Erzeugen von Ansteuersignalen für die eingangsseitigen Schaltelemente dar, mit denen sich die gewünschte hochfrequente Segmentierung (Zerhacken) der Betriebsspannung ergibt. Die antivalente Ansteuerung von jeweils zwei eingangsseitigen Schaltelementen durch den ersten oder den zweiten Treiber gelingt dabei auf besonders einfache und elegante Weise durch eine umgekehrte Polarität der beiden Sekundärspulen, so dass ein vom jeweiligen Treiber ausgegebenes High-Signal am Ausgang einer der beiden Sekundärspulen ebenfalls zu einem High-Signal und am Ausgang der komplementären Sekundärspule zu einem Low-Signal führt.

Wenn die Ausgangsschaltung der Verstärkerschaltung zwei ausgangsseitige Schaltelemente umfasst, mittels derer alternierend eine der beiden Sekundärspulen zum Abgriff der hochgesetzten Zwischenspannung auswählbar ist, kann mit einer zum zu verstärkenden Audiosignal passenden alternierenden Auswahl jeweils einer der beiden Sekundärspulen die zerhackte, bipolare und hochgesetzte Betriebsspannung wieder phasenrichtig und vorzeichenrichtig zusammengesetzt werden, so dass sich am Ausgang der Verstärkerschaltung das verstärkte Audiosignal ergibt, wobei die Verstärkung aus der Höhe der Betriebsspannung einerseits und dem Übersetzungsverhältnis des Transformators andererseits resultiert.

Bei einer besonderen Ausführungsform der Verstärkerschaltung, bei der mit einer H-Brückenschaltung und einer entsprechenden Ansteuerung der davon umfassten eingangsseitigen Schaltelemente das hochfrequente Zerhacken des Betriebsspannung bewirkt wird, ist ein von der Ansteuerschaltung ansteuerbarer dritter Treiber vorgesehen, mit dem aufgrund einer jeweiligen Ansteuerung durch die Ansteuerschaltung eine antivalente Ansteuerung der beiden ausgangsseitigen Schaltelemente bewirkbar ist. Eine solche antivalente Ansteuerung der beiden zum Kombinieren der hochgesetzten Zwischenspannung vorgesehenen ausgangsseitigen Schaltelemente ist zum Beispiel dadurch realisierbar, dass die Ansteuerschaltung ein Rechtecksignal an den dritten Treiber ausgibt und dass dieser an seinen Ausgängen zum Ansteuern der beiden ausgangsseitigen Schaltelemente einerseits das Rechtecksignal und andererseits das Rechtecksignal in invertierter Form ausgibt.

Wie oben bereits für den Wirkpfad zwischen dem ersten und zweiten Treiber und den eingangsseitigen Schaltelementen erläutert, kann eine solche Invertierung auch dadurch realisiert sein, dass dem dritten Treiber genau wie dem ersten und zweiten Treiber eine Primärspule und eine erste und zweite Sekundärspule nachgeordnet sind und dass die beiden Sekundärspulen zur Erzeugung eines ersten Signals und eines zum ersten Signal invertierten Signals mit umgekehrter Polarität angeschlossen sind.

Bei einer besonderen Ausführungsform der Verstärkerschaltung ist vorgesehen, dass die Ausgangsschaltung als Mittel zur Rekonstruktion der hochgesetzten Zwischenspannung vier ausgangsseitige Schaltelemente umfasst, durch die jeweils eine der beiden Sekundärwicklungen an jeweils einen von zwei parallelen, der Ausgangsschaltung nachfolgenden Filter, insbesondere Tiefpassfilter, schaltbar ist. Dadurch, dass sich an die Ausgangsschaltung jetzt zwei parallel geschaltete Filter anschließen, ergibt sich ein differentielles Verhalten und über den Ausgängen der beiden Filter eine verdoppelte Potentialdifferenz und mithin eine vervierfachte elektrische Leistung des am Ausgang der Verstärkerschaltung abgreifbaren Ausgangssignals.

Bei einer Ausführungsform der Verstärkerschaltung mit vier ausgangsseitigen Schaltelementen weist diese neben dem ersten und zweiten Treiber einen dritten und vierten Treiber auf, wobei der dritte und vierte Treiber über eine galvanische Entkopplung mit einer treiberseitigen Primärspule und einer ersten und zweiten Sekundärspule zur antivalenten Ansteuerung eines ersten bzw. zweiten Schaltelements der jeweils zwei in Serie geschalteten ausgangsseitigen Schaltelemente wirksam ist. Die Ansteuerung der ein- und ausgangsseitigen Schaltelemente erfolgt dabei jeweils nach dem gleichen Prinzip, so dass innerhalb der Verstärkerschaltung gleichartige Bauelemente genutzt werden und gleichartige Funktionalitäten zur Anwendung kommen. Zudem ist die Ansteuerschaltung mit den vier Treibern durch die an die Treiber anschließende galvanische Entkopplung von der Eingangsschaltung wie auch von der Ausgangsschaltung elektrisch entkoppelt.

Durch die Ansteuerschaltung ist im Betrieb der Verstärkerschaltung zur Ansteuerung der Treiber ein hochfrequentes Rechtecksignal ausgebbar und entsprechend zeichnet sich ein Verfahren zum Betrieb einer solchen Verstärkerschaltung dadurch aus, dass die Ansteuerschaltung im Betrieb der Verstärkerschaltung zur Ansteuerung der Treiber ein hochfrequentes Rechtecksignal ausgibt. Das Rechtecksignal ist dabei ein pulsweitenmoduliertes Signal und das pulsweitenmodulierte Rechtecksignal ist durch eine Rückführung des Ausgangssignals beeinflussbar oder wird durch eine Rückführung des Ausgangssignals beeinflusst, nämlich hinsichtlich seiner Frequenz und/oder der Pulsbreiten.

Der Vorteil der Erfindung und ihrer Ausgestaltungen besteht damit insbesondere darin, dass eine kompakte und energieeffiziente Verstärkerschaltung angegeben wird, die das verstärkte Ausgangssignal als potentialfreies Ausgangssignal, insbesondere als potentialfreies, niederfrequentes Audiosignal zur Verfügung stellt.

Die Funktionalität der Ansteuerschaltung ist in Hardware oder Firmware realisiert. Bei einer Realisierung in Firmware wird die Funktionalität der Firmware mit einem dafür vorgesehenen Computerprogramm vorgegeben und anschließend einem programmierbaren Logikbaustein (zum Beispiel einem PLD, einem FPGA, einem ASIC oder dergleichen) eingeprägt. Weil man auch bei der Festlegung der jeweiligen Funktionalität solcher Logikbausteine von Programmieren spricht, soll für diese Beschreibung der Begriff Computerprogramm auch die in Firmware implementierte Funktionalität umfassen, so dass die Erfindung insoweit auch ein Computerprogramm mit durch einen Computer ausführbaren Programmcodeanweisungen sowie ein Speichermedium mit einem derartigen Computerprogramm als Mittel zum Betrieb der Ansteuerschaltung betrifft. Das im Ergebnis in Form von Firmware realisierte Computerprogramm bewirkt bei der Ansteuerschaltung, dass diese die für die Ansteuerung der ein- und ausgangsseitigen Schaltelemente vorgesehenen Ansteuersignale in der jeweils vorgesehenen Frequenz und/oder mit der jeweils vorgesehenen Pulsweite erzeugt und an die der Ansteuerschaltung nachfolgenden Treiber ausgibt.

Nachfolgend wird ein Ausführungsbeispiel der Erfindung anhand der Zeichnung näher erläutert. Einander entsprechende Gegenstände oder Elemente sind in allen Figuren mit den gleichen Bezugszeichen versehen.

Das oder jedes Ausführungsbeispiel ist nicht als Einschränkung der Erfindung zu verstehen. Vielmehr sind im Rahmen der vorliegenden Offenbarung auch Abänderungen und Modifikationen möglich, insbesondere solche Varianten und Kombinationen, die zum Beispiel durch Kombination oder Abwandlung von einzelnen in Verbindung mit den im allgemeinen oder speziellen Beschreibungsteil beschriebenen sowie in den Ansprüchen und/oder der Zeichnung enthaltenen Merkmalen bzw. Elementen oder Verfahrensschritten für den Fachmann im Hinblick auf die Lösung der Aufgabe entnehmbar sind und durch kombinierbare Merkmale zu einem neuen Gegenstand oder zu neuen Verfahrensschritten bzw. Verfahrensschrittfolgen führen.

Es zeigen
- FIG 1: eine Verstärkerschaltung,
- FIG 2: und
- FIG 3: eine Signalfolge zur Ansteuerung von ein- und ausgangsseitigen Schaltelementen der Verstärkerschaltung,
- FIG 4: eine weitere Ausführungsform der Verstärkerschaltung und
- FIG 5: eine Zusammenstellung von Signalverläufen beim Betrieb der Verstärkerschaltung gemäß FIG 1.

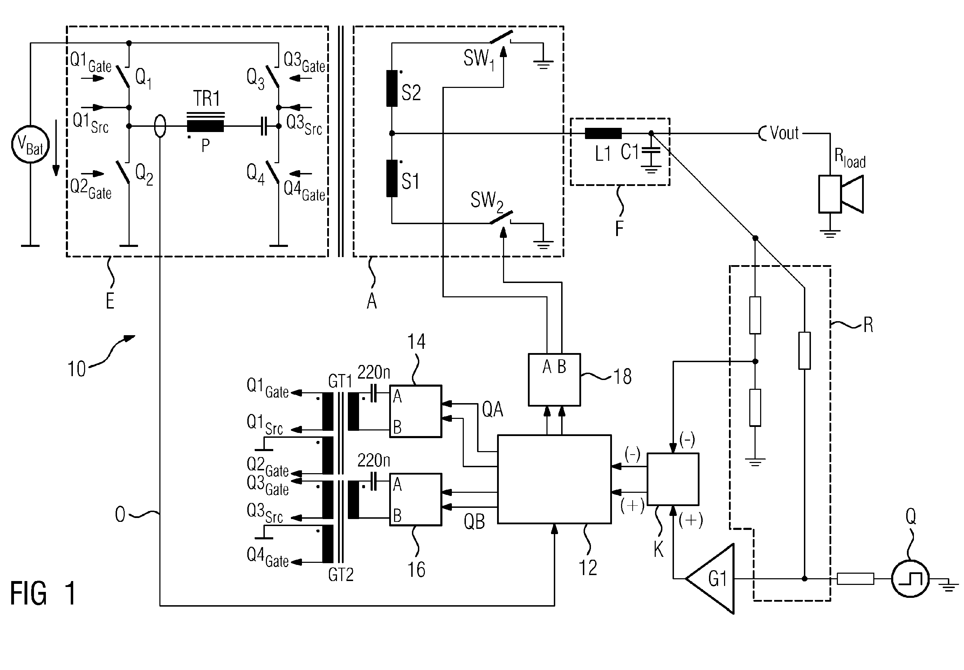

FIG 1 zeigt eine schematisch vereinfachte Ausführungsform einer Verstärkerschaltung 10 gemäß der Erfindung. Der Verstärkerschaltung 10 wird als Betriebsspannung V_{Bat} eine Gleichspannung zugeführt. Diese unipolare Spannung wird entsprechend einer Schaltstellung von vier eingangsseitigen Schaltelementen Q1, Q2, Q3, Q4 an eine Primärwicklung P eines Transformators TR angelegt. Ausgangsseitig weist der Transformator TR eine erste und eine zweite Sekundärwicklung S1, S2 auf. Jeweils eine der Sekundärwicklungen S1, S2 wird durch eine Aktivierung eines von zwei ausgangsseitigen Schaltelementen SW1, SW2 aktiviert, so dass in die jeweilige Sekundärwicklung S1, S2 induzierter Strom zu einem hier als Tiefpassfilter mit einer Induktivität L1 und einer Kapazität C1 gezeigten Filter F fließt. Der Tiefpassfilter F löscht hohe Frequenzen und das Ausgangssignal kann einem Lautsprecher (R_{load}) zugeführt werden.

Die Wirkungsweise dieses Teils der Verstärkerschaltung 10 ist dabei wie folgt: Die eingangsseitigen Schaltelemente Q1-Q4 werden hochfrequent und jeweils paarweise angesteuert. Die paarweise Ansteuerung beeinflusst einerseits die beiden eingangsseitigen Schaltelemente Q1 und Q4 und andererseits die beiden eingangsseitigen Schaltelemente Q2 und Q3. Durch die hochfrequente Ansteuerung der eingangsseitigen Schaltelemente Q1-Q4 wird die Betriebsspannung V_{Bat} entsprechend der Frequenz der Ansteuerung zerhackt. Die paarweise antivalente Ansteuerung bewirkt, dass die zerhackte Betriebsspannung V_{Bat} alternierend invertiert und nicht invertiert an die Primärwicklung P des Transformators TR gelangt, so dass die zyklische Invertierung zyklische Spannungsänderungen - und zwar auch bei einer konstanten Betriebsspannung V_{Bat} - bewirkt und aus den zyklischen Spannungsänderungen eine Änderung des induzierten Magnetfeldes und damit eine Änderung der Spannungsverhältnisse auf der Sekundärseite des Transformators TR resultiert, so dass auch die als Gleichspannung vorliegende Betriebsspannung V_{Bat} übertragen und entsprechend den Wicklungsverhältnissen des Transformators TR verstärkt wird. Im Ergebnis wird also aus der unipolaren Betriebsspannung V_{Bat} eine zerhackte, bipolare Spannung erzeugt.

Die bei der Ansteuerung der eingangsseitigen Schaltelemente Q1-Q4 verwendete, vergleichsweise hohe Frequenz (zum Beispiel in einer Größenordnung von 400 kHz) ermöglicht die Verwendung einer Primärwicklung P mit einer nur geringen Induktivität. Angesichts der jeweils nur kurzzeitig fließenden Ströme kommt es auch in einer klein dimensionierten Primärwicklung P nicht zu Sättigungseffekten.

Die auf der Eingangsseite der Verstärkerschaltung 10 zerhackte Betriebsspannung V_{Bat} wird auf der Ausgangsseite wieder kombiniert, und zwar unter Beachtung der Polarität, dort wird die hochgesetzte Betriebsspannung V_{Bat} zur Unterscheidung als Zwischenspannung bezeichnet. Zum Zusammensetzen der Zwischenspannung sind die ausgangsseitigen Schaltelemente SW1, SW2 vorgesehen, die alternierend und mit der selben Schaltfrequenz angesteuert werden wie die eingangsseitigen Schaltelemente Q1-Q4. Bei Aktivierung des ersten ausgangsseitigen Schaltelements SW1 fließt der in die erste Sekundärwicklung S1 induzierte Strom über den aus der Induktivität L1 und dem Kondensator C1 gebildeten Tiefpass (Filter F) zu einem zum Beispiel als Last an die Verstärkerschaltung 10 angeschlossenen Lautsprecher R_{load}. Bei Aktivierung des zweiten ausgangsseitigen Schaltelements SW2 fließt der in die zweite Sekundärwicklung S2 induzierte Strom über den Tiefpass L1, C1 zum Lautsprecher R_{load}. Weil der Tiefpass L1, C1 an einen Mittelabgriff zwischen der gleichsinnig geschalteten ersten und zweiten Sekundärwicklung S1, S2 angeschlossen ist, ergibt sich dabei eine alternierende Polarität des resultierenden Ausgangssignals, die mit der alternierenden Polarität der zerhackten Betriebsspannung V_{Bat} korrespondiert, so dass auf der Ausgangsseite eine echte Kombination der zunächst ebenso wie die Betriebsspannung V_{Bat} segmentierten Zwischenspannung erfolgt.

Die Verstärkungswirkung der Verstärkerschaltung 10 ergibt sich dabei aufgrund der an sich bekannten Zusammenhänge zwischen ein- und ausgangsseitiger Spannung und dem Wicklungsverhältnis der Primärwicklung P und jeder Sekundärwicklung S1, S2. Die Wicklungszahl beider Sekundärwicklungen S1, S2 ist hier identisch und ist normalerweise größer als die Wicklungszahl der Primärwicklung P, so dass die Betriebsspannung V_{Bat} entsprechend dem Verhältnis der Wicklungszahl der Primärwicklung P und der Wicklungszahl der Sekundärwicklungen S1, S2 verstärkt wird. Die Wicklungszahl der beiden Sekundärwicklungen S1, S2 kann jedoch auch kleiner als die Wicklungszahl der Primärwicklung P sein, zum Beispiel dann, wenn als Eingangssignal ein Audiosignal direkt ab Netzspannung einem üblichen 8-Ohm-Lautsprecher ohne zusätzliche Stromversorgung zugeführt werden soll.

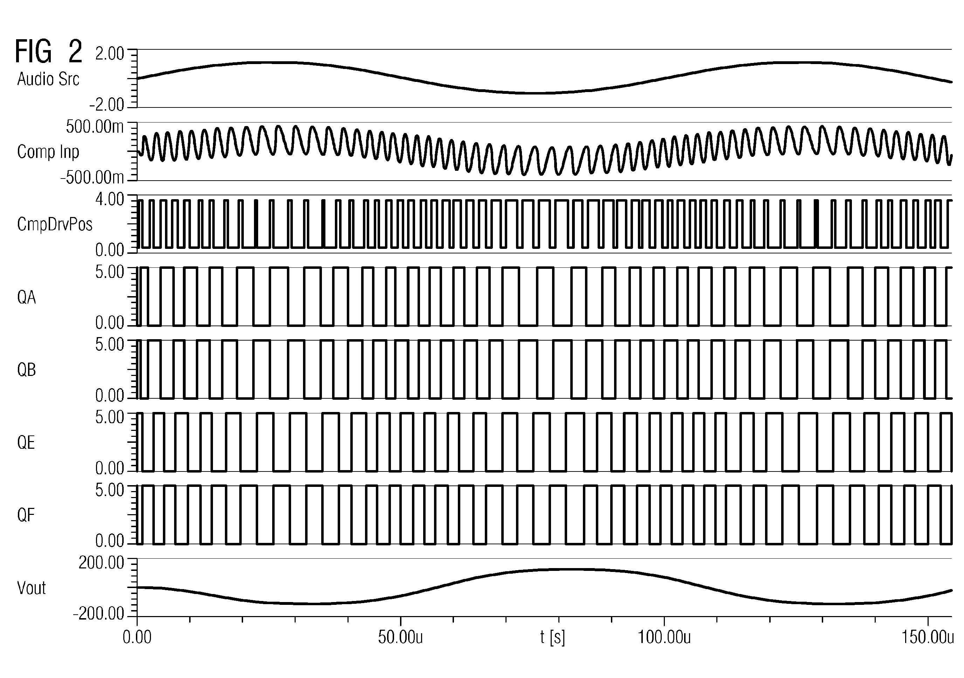

Die Ansteuerung der ein- und ausgangsseitigen Schaltelemente Q1-Q4; SW1, SW2, bei denen es sich üblicherweise um elektronische Schaltelemente, also zum Beispiel MOSFETs, handelt, erfolgt mit einer Ansteuerschaltung 12, die zum Beispiel in Form eines sogenannten PLD (programmable logic device), aber auch in Form eines ASICs oder dergleichen, realisiert sein kann. Dafür werden im Folgenden die Darstellungen in FIG 1 und FIG 2 parallel betrachtet.

Der Ansteuerschaltung 12 ist eingangsseitig ein Komparator K vorgeschaltet. Dieser erhält als Eingangssignale zum einen das zu verstärkende Audiosignal (FIG 2: "Audio Src"), für das in FIG 1 symbolisch eine Signalquelle Q eingezeichnet ist, sowie ein vom Ausgang des Filters F über die Signalrückführung R zurückgeführtes Signal (FIG 2: "Comp Inp"). Das Audiosignal ("Audio Src") wird dem Komparator K an dem in FIG 1 mit "+" gekennzeichneten Eingang (positiver, nicht-invertierender Eingang des Komparators K) zugeführt. Das zurückgeführte Signal ("Comp Inp") wird dem Komparator K an dem in FIG 1 mit "-" gekennzeichneten Eingang (negativer, invertierender Eingang des Komparators K) zugeführt.

Der Komparator K vergleicht die beiden ihm zugeführten Eingangssignale "Audio Src" und "Comp Inp". Die Grundfrequenz des zurückgeführten Signals ("Comp Inp") entspricht der Grundfrequenz des Audiosignals ("Audio Src"). Dem zurückgeführten Signal ("Comp Inp") ist aber die ursprüngliche Trägerfrequenz der Pulsweitenmodulation, hier also zum Beispiel 400 kHz, als Sinussignal überlagert. Der Umstand, warum das zurückgeführte Signal auf einer Pulsweitenmodulation basiert und noch Reste der Trägerfrequenz umfasst, ergibt sich im weiteren Verlauf der Beschreibung, wenn die Ansteuerung der ein- und ausgangsseitigen Schaltelemente Q1-Q4, SW1, SW2 erläutert wird.

Der Komparator K hat einen ersten, in FIG 1 mit "+" gekennzeichneten Ausgang und einen komplementären, zweiten, in FIG 1 mit "-" gekennzeichneten Ausgang. Am ersten Ausgang des Komparators K wird ein Signal generiert, das anzeigt, welches der beiden oben beschriebenen Eingangssignale höher ist. Wenn die Spannung des Audiosignals ("Audio Src") am positiven, nicht-invertierenden Eingang höher ist als die Spannung des zurückgeführten Signals ("Comp Inp") am negativen, invertierenden Eingang, so nähert sich die Ausgangsspannung der positiven Versorgungsspannung des Komparators K. Bei umgekehrten Verhältnissen geht die Ausgangsspannung gegen die negative Versorgungsspannung des Komparators K. Das am ersten, positiven Ausgang des Komparators K generierte Signal ist in FIG 2 als "CompDrvPos" dargestellt und es handelt sich um ein entsprechend dem zu verstärkenden Audiosignal pulsweitenmoduliertes Signal. Das am zweiten, negativen Ausgang des Komparators K generierte Signal ist nicht separat dargestellt. Es handelt sich aber um ein zu dem am ersten Ausgang generierten Signal komplementäres, invertiertes Signal.

Der Ansteuerschaltung 12 werden die beiden vom Komparator generierten Signale, also das positive Signal "CmprDrvPos" und das negative, invertierte Signal, zugeführt. Die Ansteuerschaltung 12 umfasst im Wesentlichen die Funktionalität zweier getoggelter FlipFlops, für jeden Eingang eines. Der Ausgang dieser FlipFlops wechselt mit jeder steigenden Flanke der vom Komparator K gelieferten Signale. Dadurch ergibt sich ein 50:50 Tastverhältnis (zwei aufeinander folgende Pulse haben jeweils eine gleiche Pulsbreite) der von der Ansteuerschaltung 12 generierten Signale und zwar unabhängig vom Tastverhältnis der zugrunde liegenden Signale, nämlich der vom Komparator K generierten Signale. Des Weiteren haben die von der Ansteuerschaltung 12 generierten Signale jeweils genau die halbe Frequenz der vom Komparator K gelieferten Signale, weil durch die Toggle-FlipFlops jeweils nur die steigenden Flanken (und nicht die steigenden und die fallenden Flanken) der vom Komparator K gelieferten Signale ausgewertet werden.

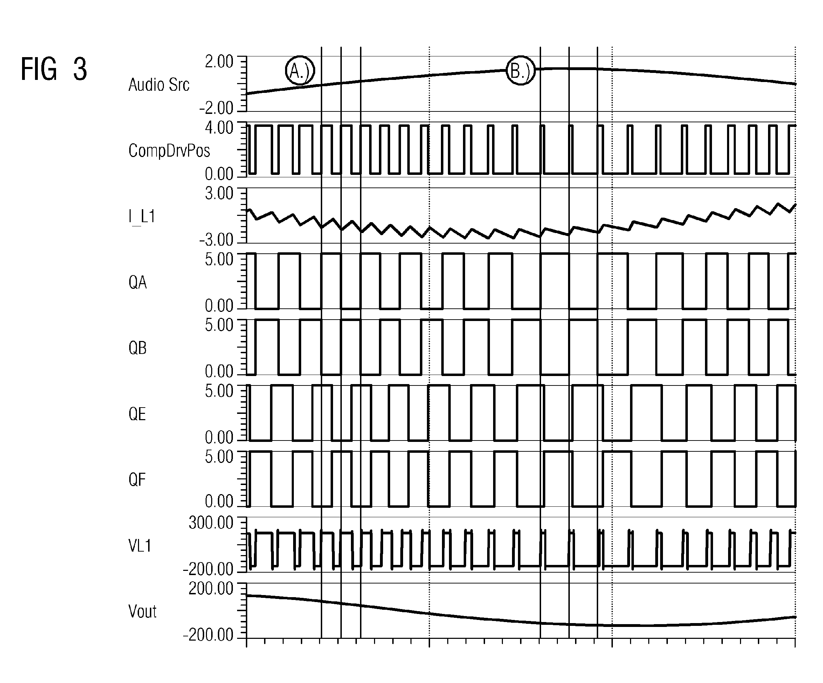

Die Darstellung in FIG 3 macht dies anhand eines vergrößerten Ausschnitts aus der Darstellung in FIG 2 auch graphisch deutlich. Mit den jeweils in Dreiergruppen eingezeichneten vertikalen Linien sind drei aufeinander folgende steigende Flanken des am positiven Ausgang des Komparators K anstehenden Signals "CmpDrvPos" markiert. Man erkennt, dass daraus eine steigende, eine fallende und wieder eine steigende Flanke in einem ersten und mit "QA" bezeichneten, von der Ansteuerschaltung 12 generierten Signal resultiert. Die Abstände zwischen den in den beiden Dreiergruppen ersten und zweiten vertikalen Linien und den zweiten und dritten vertikalen Linien sind jeweils gleich. Das bedeutet, dass auch die aufeinander folgenden positiven und negativen Pulse in dem resultierenden Signal QA jeweils gleich breit sind. Das ist das oben schon erwähnte 50:50 Tastverhältnis der Pulsbreiten.

Das von der Ansteuerschaltung 12 generierte Signal QA wird zur Ansteuerung einzelner eingangsseitiger Schaltelemente Q1-Q4 verwendet. Dazu wird das Signal QA einem ersten Treiber 14 zugeführt, der daraus ein Ansteuersignal und im Rahmen einer galvanischen Entkopplung mittels einer Primärwicklung und einer ersten und zweiten Sekundärwicklung ein Ansteuersignal zur Ansteuerung des ersten eingangsseitigen Schaltelements Q1 sowie ein invertiertes Ansteuersignal zur Ansteuerung des zweiten eingangsseitigen Schaltelements Q2 erzeugt. In gleicher Weise erfolgt die Ansteuerung der zweiten und dritten eingangsseitigen Schaltelemente Q3, Q4. Dafür erzeugt die Ansteuerschaltung 12 zunächst ein im Vergleich zum Signal QA invertiertes Signal QB. Dieses wird einem zweiten Treiber 16 zugeführt, der daraus ein Ansteuersignal und im Rahmen einer galvanischen Entkopplung mittels einer Primärwicklung und einer ersten und zweiten Sekundärwicklung ein Ansteuersignal zur Ansteuerung des dritten eingangsseitigen Schaltelements Q3 und ein invertiertes Ansteuersignal zur Ansteuerung des vierten eingangsseitigen Schaltelements Q4 erzeugt.

Die Ansteuerung der eingangsseitigen Schaltelemente Q1-Q4 und das damit bewirkte Zerhacken der Betriebsspannung V_{Bat} ist damit auf das Audiosignal "Audio Src" bezogen, indem aus dem pulsweitenmodulierten Signal am Ausgang des das Audiosignal verarbeitenden Komparators K pulsweitenmodulierte Ansteuersignale QA, QB zur Ansteuerung der eingangsseitigen Schaltelemente Q1-Q4 entstehen. Die Besonderheit der pulsweitenmodulierten Ansteuersignale QA, QB besteht dabei in ihrem festen 50:50 Tastverhältnis, so dass sich die Schaltung insgesamt vereinfacht, denn ein ansonsten variierendes Tastverhältnis, das zu einem bestimmten Zeitpunkt zum Beispiel 99:1 beträgt, erfordert eine Ansteuerung des jeweiligen Schaltelements mit einer sehr hohen Frequenz, was eine Ansteuerung des jeweiligen Schaltelements mit einer entsprechend hohen Treiberleistung erfordert.

Jeder der beiden auf die Eingangsseite der Verstärkerschaltung 10 wirkenden Treiber 14, 16 speist eine Primärwicklung und beeinflusst damit jeweils eine erste und eine zweite Sekundärwicklung. Ein vom ersten Treiber 14 erzeugtes Signal wird demnach in antivalente Schaltsignale für das erste und zweite eingangsseitige Schaltelement Q1, Q2 umgesetzt, derart, dass das erste und zweite eingangsseitige Schaltelement Q1, Q2 stets antivalent geöffnet oder geschlossen ist. Gleiches gilt für die Wirkungsweise des zweiten Treibers 16 und die dortige Erzeugung von Schaltsignalen zum antivalenten Öffnen und Schließen des dritten und vierten eingangsseitigen Schaltelements Q3, Q4. Das an den ersten und zweiten Treiber 14, 16 von der Ansteuerschaltung 12 ausgegebene Schaltsignal ist ein symmetrisches Rechtecksignal und das an den zweiten Treiber 16 ausgegebene Steuersignal ist im Verhältnis zu dem an den ersten Treiber 14 ausgegebenen Steuersignal invertiert, so dass sich an den eingangsseitigen Schaltelementen die alternierende Schaltfolge Q1, Q4; Q3, Q2; Q1, Q4; Q3, Q2, usw. ergibt. Dies führt zu dem oben bereits beschriebenen, hochfrequenten Zerhacken der Betriebsspannung V_{Bat} und basiert auf der paarweisen und antivalenten Ansteuerung der eingangsseitigen Schaltelemente Q1-Q4.

Die Ansteuerung der ausgangsseitigen Schalter SW1, SW2 erfolgt auf Basis des komplementären Ausgangssignals des Komparators K und ansonsten analog. Das komplementäre Ausgangssignals des Komparators K ist in den Figuren nicht dargestellt, dennoch kann die Verarbeitung des komplementären Ausgangssignals des Komparators K durch die Ansteuerschaltung 12 und der davon umfassten Toggle-FlipFlops leicht nachvollzogen werden, wenn in dem zum komplementären Ausgangssignals des Komparators K inversen positiven Ausgangssignal "CmpDrvPos" anstelle der im komplementären Ausgangssignal des Komparators K relevanten positiven Flanken die negativen Flanken betrachtet werden. Jedenfalls (vgl. FIG 2 und speziell die vergrößerte Darstellung in FIG 3) ergibt sich mit jeder steigenden Flanke des komplementären Ausgangssignals des Komparators K (also jeder fallenden Flanke des positiven Ausgangssignals "CmpDrvPos") eine Umschaltung des einen dritten Treiber 18 ansteuernden Toggle-FlipFlops der Ansteuerschaltung 12, so dass die zu den Signalen QA, QB phasenverschobenen Ansteuersignale QE, QF zur Ansteuerung der beiden ausgangsseitigen Schaltelemente SW1, SW2 entstehen. Das Tastverhältnis der Ansteuersignale zur Ansteuerung der ausgangsseitigen Schaltelemente SW1, SW2 beträgt ebenso wie das Tastverhältnis der Ansteuersignale zur Ansteuerung der eingangsseitigen Schaltelemente Q1-Q4 50:50, so dass sich auch ausgangsseitig die oben bereits beschriebenen und mit dem festen Tastverhältnis einhergehenden Vorteile ergeben. Indem die Ansteuersignale QA, QB, QE, QF für die ein- und die ausgangsseitigen Schaltelemente Q1-Q4; SW1, SW2 auf Basis desselben Ausgangssignals "CmpDrvPos" des Komparators K, nämlich zum einen aufgrund dieses Ausgangssignals und zum anderen aufgrund eines im Vergleich dazu invertierten Signals, entstehen, werden die ein- und die ausgangsseitigen Schaltelemente Q1-Q4; SW1, SW2 mit derselben Frequenz, aber mit einer variablen Phasenverschiebung angesteuert. Die Phasenverschiebung richtet sich dabei nach der jeweiligen Pulsbreite des Ausgangssignals "CmpDrvPos" des Komparators K und damit nach dem zu verstärkenden Audiosignal "Audio Src". Auf der anderen Seite wird der Komparator K durch die Rückführung des Ausgangssignals der Verstärkerschaltung 10 zum Komparator K durch den Rest der im Ausgangssignal noch enthaltenen Schaltfrequenz zur Ansteuerung der ein- und ausgangsseitigen Schaltelemente Q1-Q4; SW1, SW2 "getriggert".

Die Phasenverschiebung der erzeugten ein- und ausgangsseitigen Ansteuersignale QA, QB; QE, QF resultiert also aus dem pulsweitenmodulierten Signal als Ergebnis des vom Komparator K anhand des zu verstärkenden Audiosignals durchgeführten Vergleichs und repräsentiert damit die Frequenz des zu verstärkenden Audiosignals. Durch Tiefpassfilterung mit dem Filter F entsteht im Ergebnis das verstärkte Signal Vₒᵤₜ (FIG 2, FIG 3), das einem in FIG 1 als R_{load} dargestellten Lautsprecher zugeführt werden kann. Die Verstärkung des Audiosignals (hier gezeigt von einem ursprünglichen Wertebereich von +/- 2 Volt in einen Wertebereich von +/- 200 Volt) richtet sich nach der Größe der der Verstärkungsschaltung 10 zugeführten Betriebsspannung V_{Bat} und dem Übertragungsverhältnis des Transformators TR.

Die Darstellung in FIG 3 beantwortet auch die Frage, wie sich als Spannungssignal ("V_L1") vor dem ausgangsseitigen Tiefpassfilter L1, C1 ein pulsweitenmoduliertes Signal ergeben kann, wenn nur "fixed 50% duty cycle signals"(50:50 Tastverhältnis) verwendet werden. Dies liegt an einer Variation im Sinne einer Modulation der Phasenverschiebung der Ansteuersignale zur Ansteuerung der ein- und ausgangsseitigen Schaltelemente Q1-Q4, SW1, SW2. Wenn eines der Steuersignale QA, QB zur Ansteuerung der eingangsseitigen Schaltelemente Q1-Q4 und eines der Steuersignale zur Ansteuerung der ausgangsseitigen Schaltelemente SW1, SW2 einer logischen UND-Verknüpfung unterworfen werden, ergibt sich ein pulsweitenmoduliertes und frequenzmoduliertes Signal V_L1. In FIG 3 ist dies für die mit "A.)" und "B.)" bezeichneten Positionen hervorgehoben und wird im Folgenden mit Bezug auf diese beiden Positionen erläutert:

### Position A.)

Wenn das Audiosignal ("Audio Src") nahe Null ist, ergibt sich in dem vom Komparator K erzeugten Signal CmpDrvPos eine maximale Schaltfrequenz. Aufgrund der freischwingenden Natur der Verstärkerschaltung 10 ist die Schaltfrequenz und das PulsPausen Verhältnis variabel. Es zeigt sich, dass bei einem Eingangssignal im Bereich von Null Volt die Frequenz am höchsten ist. Eine Phasenverschiebung zwischen den Signalen "QA" und "QE" oder "QB" und "QF" ist genau oder näherungsweise 90°, denn der ausgangsseitige Filter soll keine NF-Spannungsänderung erfahren, so dass in zwei aufeinander folgenden Zyklen jeweils gleichviel Energie hineingegeben und entnommen wird. Diese Phasenverschiebung führt zu einem Signalverlauf vor dem Tiefpassfilter L1, C1 mit einer Frequenz, die doppelt so hoch ist wie die Schaltfrequenz. Die Amplitude des generierten Signals liegt bei +/- Betriebsspannung V_{Bat} mal Übertragungsverhältnis des Transformators TR.

### Position B.)

Bei einem Maximalwert oder in der Nähe eines Maximalwertes des zu verstärkenden Audiosignals ("Audio Src") ergibt sich eine minimale Schaltfrequenz. Die Phasenverschiebung zwischen den Signalen "QA" und "QE" oder "QB" und "QF" ist genau oder näherungsweise 180°. Dies führt zu einem Signalverlauf vor dem Tiefpassfilter L1, C1 mit einer vergleichsweise kurzen Pulszeit. Nicht dargestellt ist eine Situation bei einem nächstfolgenden Extremwert des Audiosignals. Dann ist der Sägezahn innerhalb einer Periode im Vergleich zur Situation in Position B.) zur anderen Seite verschoben, so dass sich eine kleine oder nur eine minimale Phasenverschiebung ergibt. Dies führt zu einem Signalverlauf vor dem Tiefpassfilter L1, C1 mit einer langen Pulszeit.

Die Tiefpassfilterung formt das Signal am Eingang des Tiefpassfilters ("V_L1") wieder in ein Analogsignal ("Vₒᵤₜ") um und zwar in eine entsprechend der Betriebsspannung V_{Bat} und dem Übertragungsverhältnis des Transformators TR verstärkte Form des ursprünglichen Audiosignals.

Für Schutzzwecke erfolgt über einen nur schematisch vereinfacht dargestellten Stromsensor, zum Beispiel einen Shunt-Widerstand, eine Messung des in die Primärwicklung P fließenden Stroms, um Überstromsituationen erkennen zu können. Ein aufgrund der Strommessung resultierendes Sensorsignal wird der Ansteuerschaltung 12 zugeführt (Überstromüberwachung O), die den Messwert verarbeitet und zum Beispiel bei einer Überstromsituation die an die Treiber 14-18 ausgegebenen Schaltsignale unterdrückt oder verringert, um den Stromfluss zur Primärwicklung P in jeweils einem Schaltintervall zu unterbinden bzw. zu reduzieren.

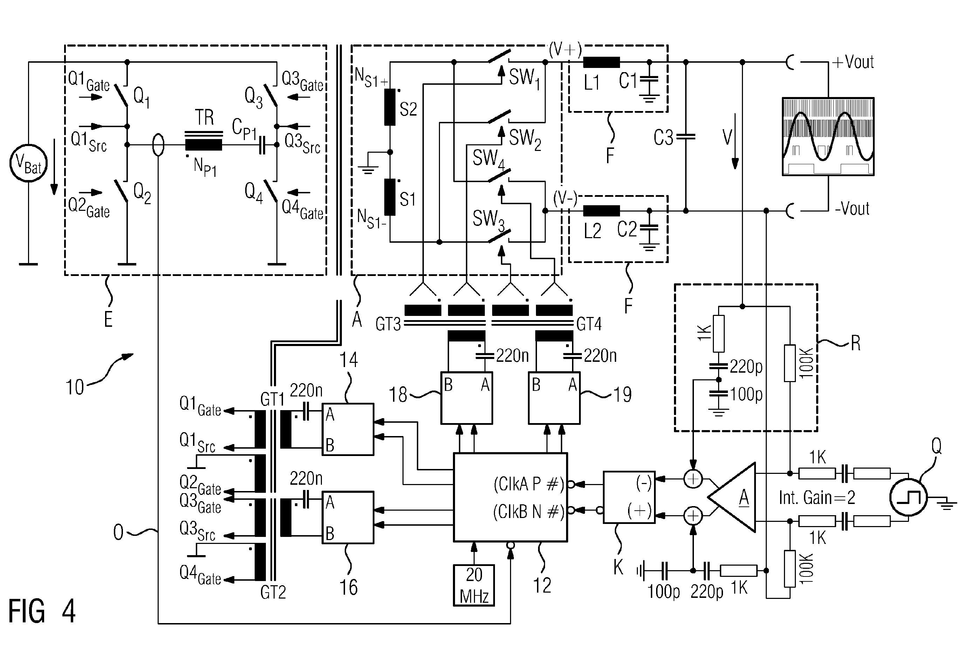

FIG 4 zeigt eine besondere Ausführungsform einer Verstärkerschaltung 10 auf Basis des Prinzips der in FIG 1 gezeigten Verstärkerschaltung 10. Der Unterschied zu der Verstärkerschaltung 10 in FIG 1 besteht vor allem darin, dass anstatt vorher (FIG 1) zweier ausgangsseitiger Schaltelemente SW1, SW2 nunmehr vier ausgangsseitige Schaltelemente SW1-SW4 und in jedem ausgangsseitigen Zweig der Verstärkerschaltung 10 ein eigener Tiefpassfilter F (L1, C1; L2, C2) vorgesehen sind. Damit ergibt sich ein differentielles Ausgangssignal, das nicht mehr auf Massepotential bezogen ist. Stattdessen ergibt sich an einem ausgangsseitigen Zweig der Verstärkerschaltung 10 ein positives Ausgangssignal +Vₒᵤₜ und an dem anderen Zweig ein negatives Ausgangssignal -Vₒᵤₜ. Diese einem Lautsprecher oder dergleichen zuführbare Ausgangsspannung V ist die Gesamtpotentialdifferenz, die im Vergleich zu der mit der Verstärkerschaltung 10 in FIG 1 erzeugten Ausgangsspannung verdoppelt ist, so dass sich eine vierfache elektrische Leistung ergibt, weil die elektrische Spannung in die elektrische Leistung im Quadrat eingeht.

Die Form der PWM-Signale zur Ansteuerung der ein- und ausgangsseitigen Schaltelemente Q1-Q4; SW1-SW4 ergibt sich aufgrund einer Rückführung F der Ausgangssignals +Vₒᵤₜ und -Vₒᵤₜ zur Ansteuerschaltung 12. Die zurückgeführten Ausgangssignale werden zusammen mit dem von der Signalquelle Q gelieferten Audiosignal einem differentiellen Verstärker AP und einem Komparator K zugeführt. Der Verlauf der Ausgangssignale +Vₒᵤₜ, -Vₒᵤₜ bestimmt dabei wie oben beschrieben die Arbeitsweise der Ansteuerschaltung 12 und damit mittelbar die von der Ansteuerschaltung 12 bewirkte Ansteuerung der Treiber 14, 16, 18, 19 (zur Ansteuerung der jetzt vier ausgangsseitigen Schaltelemente SW1-SW4 weist die Verstärkerschaltung 10 jetzt auch ausgangsseitig zwei Treiber 18, 19 auf) und damit schließlich auch die Ansteuerung der ein- und ausgangsseitigen Schaltelemente Q1-Q4; SW1-SW4.

Das Ausgangssignal des Komparators K ist wie bereits beschrieben davon abhängig, an welchem seiner beiden Eingänge ein höheres Potential ansteht. Die Eingänge des Komparators K werden im Rahmen der Rückführung R und durch das zu verstärkende Audiosignal versorgt und aufgrund der Dynamik der zurückgeführten Ausgangssignale +Vₒᵤₜ, -Vₒᵤₜ ergibt sich am Ausgang des Komparators K ein Taktsignal, das hier der Ansteuerschaltung 12 in Form eines ersten Taktsignals ClkA und eines im Vergleich zum ersten Taktsignal ClkA invertierten zweiten Taktsignals ClkB zur Verfügung gestellt wird. Das erste Taktsignal ClkA entspricht dem bereits im Zusammenhang mit FIG 1 erläuterten Eingangssignal für die dortige Ansteuerschaltung, nämlich dem als "CmpDrvPos" bezeichneten Eingangssignal. Das zweite Taktsignal ClkB entspricht damit einer invertierten Form des als "CmpDrvPos" bezeichneten Eingangssignals.

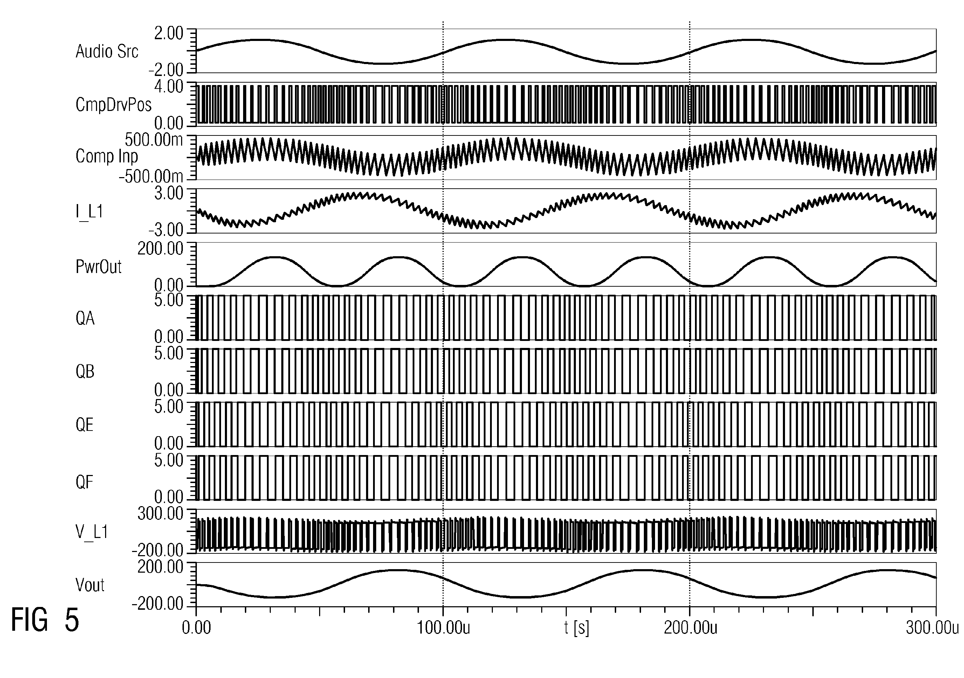

FIG 5 zeigt eine Zusammenstellung von Signalverläufen beim Betrieb der Verstärkerschaltung 10 gemäß FIG 1. Von oben nach unten stellt zunächst "Audio Src" den Verlauf des zu verstärkenden Audiosignals dar. Bei dem Audiosignal handelt es sich um ein sinusförmiges Eingangssignal mit einer maximalen Amplitude von ca. +/- 1,5 Volt.

Darunter ist als "CmpDrvPos" das vom Komparator K an dessen positivem Ausgang generierte Signal gezeigt. Es handelt sich um ein pulsweitenmoduliertes Signal.

"CmpInp" ist das aus der Verstärkerschaltung 10 zurückgeführte und dem Komparator K zusammen mit dem Audiosignal "Audio Src" zugeführte Signal. Beide Signale bilden damit die Grundlage für das vom Komparator K generierte Ausgangssignal "CmpDrvPos". Die im zurückgeführten Signal enthaltene Oberschwingung ist das Ergebnis der pulsweitenmodulierten Ansteuerung der ein- und ausgangsseitigen Schaltelemente Q1-Q4, SW1, SW2 und bildet die Grundlage für die Schaltfrequenz der von der Ansteuerschaltung 12 erzeugten Ansteuersignale QA, QB, QE, QF.

Mit "I_L1" ist der in die Induktivität L1 des Tiefpassfilters L1, C1 fließende Strom gezeigt. Darunter stellt "PwrOut" die elektrische Leistung dar, die in die Last R_{load}, also zum Beispiel einen Lautsprecher, abgegeben wird.

In einer nächsten Sektion sind mit "QA", "QB", "QE" und "QF" Schaltsignale zur Ansteuerung der ein- und ausgangsseitigen Schaltelemente Q1-Q4; SW1, SW2 gezeigt. Es handelt sich jeweils um pulsweitenmodulierte Signale und "QB" ist das invertierte Signal zu "QA", genauso wie "QF" das invertierte Signal zu "QE" ist. Die Signale "QA" und "QB" werden an den beiden in FIG 1 mit A und B bezeichneten Ausgängen des ersten und zweiten Treibers 14, 16 zur Ansteuerung der eingangsseitigen Schaltelemente Q1-Q4 ausgegeben. Die Signale "QE" und "QF" werden an den beiden in FIG 1 mit A und B bezeichneten Ausgängen des dritten Treibers 18 zur Ansteuerung der ausgangsseitigen Schaltelemente SW1, SW2 ausgegeben, und zwar mit einem 50:50 Tastverhältnis (50% fixed duty cycle). Dafür wird das vom Komparator K kommende PWM-Signal durch die Ansteuerschaltung 12 in mehrere Rechtecksignale jeweils mit einem 50:50 Tastverhältnis umgewandelt, welche zur Ansteuerung der ein- und ausgangsseitigen Schaltelemente Q1-Q4, SW1, SW2 gegeneinander phasenverschoben sind.

Wiederum darunter ist mit "V L1" der Verlauf der Spannung vor dem ausgangsseitigen Tiefpassfilter L1, C1 gezeigt. Das Spannungssignal ist pulsweitenmoduliert und frequenzmoduliert. Die Spannungserhöhung ist dabei das Ergebnis der Übertragung durch den Transformator TR und betragsmäßig durch das Wicklungsverhältnis der Wicklungszahl der Primärwicklung P zu den Wicklungszahlen der beiden Sekundärwicklungen S1, S2 bestimmt. Abschließend ist mit "Vₒᵤₜ" der zeitliche Verlauf des Ausgangssignals V gezeigt, also der Verlauf der Spannung nach dem ausgangsseitigen Tiefpassfilter L1, C1.

Obwohl die Erfindung im Detail durch das Ausführungsbeispiel näher illustriert und beschrieben wurde, so ist die Erfindung nicht durch das oder die offenbarten Beispiele eingeschränkt und andere Variationen können vom Fachmann hieraus abgeleitet werden, ohne den Schutzumfang der Erfindung zu verlassen.

Einzelne im Vordergrund stehende Aspekte der hier eingereichten Beschreibung lassen sich damit kurz wie folgt zusammenfassen: Angegeben werden eine Verstärkerschaltung 10 und ein Verfahren zum Betrieb einer Verstärkerschaltung 10, wobei die Verstärkerschaltung 10 Folgendes umfasst: Eine Eingangsschaltung mit Mitteln Q1, Q2, Q3, Q4 zum Zerhacken einer Betriebsspannung V_{Bat} Gemäß einem zu verstärkenden Audiosignal. Einen hochsetzenden Transformator TR mit einer Primärwicklung P und einer ersten und zweiten Sekundärwicklung S1, S2, an dessen Primärwicklung P die gemäß dem zu verstärkenden Audiosignal zerhackte Betriebsspannung V_{Bat} anlegbar ist oder angelegt wird und an dessen Sekundärwicklungen S1, S2 die hochgesetzte und entsprechend dem zu verstärkenden Audiosignal zerhackte Betriebsspannung V_{Bat} abgreifbar ist oder abgegriffen wird. Eine Ausgangsschaltung mit Mitteln SW1, SW2, SW3, SW4 zur Rekonstruktion der entsprechend dem Audiosignal zerhackten Betriebsspannung V_{Bat} und einen der Ausgangsschaltung nachfolgenden Tiefpassfilter L1, C1, an dem die rekonstruierte, hochgesetzte Betriebsspannung V_{Bat} als Ausgangssignal V abgreifbar ist oder abgegriffen wird.

### Bezugszeichenliste

- 10: Verstärkerschaltung
- 12: Ansteuerschaltung
- 14: Treiber
- 16: Treiber
- 18,19: Treiber

- A: Ausgangsschaltung
- AP: Verstärker
- C1: Kapazität
- ClkA: erstes Taktsignal
- ClkB: zweites Taktsignal
- E: Eingangsschaltung
- F: Filter
- K: Komparator
- L1: Induktivität
- O: Überstromüberwachung
- P: Primärwicklung
- Q: Signalquelle
- Q1: eingangsseitiges Schaltelement
- Q2: eingangsseitiges Schaltelement
- Q3: eingangsseitiges Schaltelement
- Q4: eingangsseitiges Schaltelement
- QA: pulsweitenmoduliertes Ansteuersignal (für eines der eingangsseitigen Schaltelemente)
- QB: invertiertes pulsweitenmoduliertes Ansteuersignal (für eines der eingangsseitigen Schaltelemente)
- QE: pulsweitenmoduliertes Ansteuersignal (für eines der ausgangsseitigen Schaltelemente)
- QF: invertiertes pulsweitenmoduliertes Ansteuersignal (für eines der ausgangsseitigen Schaltelemente)
- R: Rückführung
- R_{load}: Lautsprecher
- S1: Sekundärwicklung
- S2: Sekundärwicklung
- SW1: ausgangsseitiges Schaltelement
- SW2: ausgangsseitiges Schaltelement
- SW3: ausgangsseitiges Schaltelement
- SW4: ausgangsseitiges Schaltelement
- TR: Transformator
- V: Ausgangssignal
- V_{Bat}: Betriebsspannung
- Vₒᵤₜ: verstärktes Signal

## Patentansprüche

1. Verstärkerschaltung (10) mit einer Eingangsschaltung (E), einem insbesondere hochsetzenden Transformator (TR) mit einer Primärwicklung (P) und einer ersten und zweiten Sekundärwicklung (S1, S2), einer Ausgangsschaltung (A) und zumindest einem Filter (F), insbesondere in Form eines Tiefpassfilters,
wobei die Eingangsschaltung (E) und die Ausgangsschaltung (A) über den Transformator (TR) galvanisch entkoppelt verbunden sind,
wobei die Eingangsschaltung (E) Mittel (Q1, Q2, Q3, Q4) zum Zerhacken einer der Eingangsschaltung (E) zuführbaren Betriebsspannung (V_{Bat}) aufweist,
wobei die Mittel (Q1, Q2, Q3, Q4) zum Zerhacken der Betriebsspannung (V_{Bat}) mit entsprechend einem zu verstärkenden Audiosignal (Audio Src) pulsweitenmodulierten Ansteuersignalen (QA, QB) ansteuerbar sind,
wobei an die Primärwicklung (P) die zerhackte Betriebsspannung (V_{Bat}) anlegbar ist und an den Sekundärwicklungen (S1, S2) eine hochgesetzte Zwischenspannung abgreifbar ist, und
mit einer Ausgangsschaltung (A) mit Mitteln (SW1, SW2; SW1, SW2, SW3, SW4) zum phasenrichtigen Zusammensetzen der Zwischenspannung,
wobei die Mittel (SW1, SW2; SW1-SW4) zum Zusammensetzen der Zwischenspannung mit entsprechend dem zu verstärkenden Audiosignal (Audio Src) pulsweitenmodulierten Ansteuersignalen (QE, QF) ansteuerbar sind,
wobei an dem der Ausgangsschaltung (A) nachfolgenden Filter (F) als Ausgangssignal (V) eine entsprechend der Betriebsspannung (V_{Bat}) und dem Übertragungsverhältnis des Transformators (TR) verstärkte Form des Audiosignal (Audio Src) abgreifbar ist.

2. Verstärkerschaltung (10) nach Anspruch 1, wobei zwischen den pulsweitenmodulierten Ansteuersignalen (QA, QB) zum Zerhacken der Betriebsspannung (V_{Bat}) und den pulsweitenmodulierten Ansteuersignalen (QE, QF) zum Zusammensetzen der Zwischenspannung eine durch das zu verstärkende Audiosignal (Audio Src) bestimmte Phasenverschiebung besteht.

3. Verstärkerschaltung (10) nach Anspruch 2, wobei die Ansteuersignale (QA, QB, QE, QF) aufgrund eines Ausgangssignals eines Komparators (K) bildbar sind, dem einerseits das zu verstärkende Audiosignal (Audio Src) und andererseits das zurückgeführte Ausgangssignal (V) zuführbar sind, wobei sich die Phasenverschiebung zwischen den Ansteuersignalen (QA, QB, QE, QF) entsprechend einer jeweiligen Pulsbreite des am Ausgang des Komparators (K) resultierenden pulsweitenmodulierten Signals (CmpDrvPos) als Ergebnis des Vergleichs von zurückgeführtem Ausgangssignal (V) und zu verstärkendem Audiosignal (Audio Src) ergibt.

4. Verstärkerschaltung (10) nach einem der vorangehenden Ansprüche, wobei die Eingangsschaltung (E) als H-Brückenschaltung ausgeführt ist und als Mittel (Q1, Q2, Q3, Q4) zum Zerhacken der Betriebsspannung (V_{Bat}) entsprechend dem zu verstärkenden Audiosignal (Audio Src) vier Schaltelemente (Q1-Q4) fungieren, die mit der an einen Mittelabgriff von je zwei in Serie geschalteten Schaltelementen (Q1, Q2; Q3, Q4) angeschlossenen Primärwicklung (P) des Transformators (TR) die H-Brücke bilden.

5. Verstärkerschaltung (10) nach Anspruch 4, wobei die vier Schaltelemente (Q1-Q4) hochfrequent und paarweise ansteuerbar sind, wobei die paarweise Ansteuerung alternierend jeweils eines der jeweils zwei in Serie geschalteten Schaltelemente (Q1, Q2; Q3, Q4) betrifft.

6. Verstärkerschaltung (10) nach Anspruch 5, mit einer Ansteuerschaltung (12) und einem ersten und einem zweiten von der Ansteuerschaltung (12) angesteuerten Treiber (14, 16), wobei der erste und zweite Treiber (14, 16) über eine galvanische Entkopplung mit einer treiberseitigen Primärspule und einer ersten und zweiten Sekundärspule zur antivalenten Ansteuerung eines ersten bzw. zweiten Schaltelements (Q1, Q3; Q2, Q4) der jeweils zwei in Serie geschalteten Schaltelemente (Q1, Q2; Q3, Q4) wirksam ist.

7. Verstärkerschaltung (10) nach einem der vorangehenden Ansprüche, wobei die Ausgangsschaltung (12) zwei ausgangsseitige Schaltelemente (SW1, SW2) umfasst, mittels derer alternierend eine der beiden Sekundärspulen (S1, S2) zum Abgriff der hochgesetzten Zwischenspannung auswählbar ist.

8. Verstärkerschaltung (10) nach Anspruch 6 und Anspruch 7, mit einem dritten Treiber (18), mit dem aufgrund einer Ansteuerung durch die Ansteuerschaltung (12) eine antivalente Ansteuerung der beiden ausgangsseitigen Schaltelemente (SW1, SW2) bewirkbar ist.

9. Verstärkerschaltung (10) nach einem der Ansprüche 1 bis 6, wobei die Ausgangsschaltung (A) vier ausgangsseitige Schaltelemente (SW1-SW4) umfasst, durch die jeweils eine der beiden Sekundärwicklungen (S1, S2) an jeweils einen von zwei parallelen, der Ausgangsschaltung (A) nachfolgenden Tiefpassfilter (F) schaltbar ist.

10. Verstärkerschaltung (10) nach Anspruch 6 und Anspruch 9, mit einem dritten und vierten Treiber (18, 19), wobei der dritte und vierte Treiber (18, 19) über eine galvanische Entkopplung mit einer treiberseitigen Primärwicklung und einer ersten und zweiten Sekundärwicklung zur antivalenten Ansteuerung eines ersten bzw. zweiten Schaltelements (SW1, SW4; SW2, SW3) der jeweils zwei in Serie geschalteten ausgangsseitigen Schaltelemente (SW1, SW4; SW2, SW3) wirksam ist.

11. Verstärkerschaltung (10) nach einem der Ansprüche 6, 7 oder 10, wobei durch die Ansteuerschaltung (12) zur Ansteuerung der Treiber (14, 16, 18; 14, 16, 18, 19) ein hochfrequentes Rechtecksignal mit einem festen 50:50 Tastverhältnis ausgebbar ist.

12. Verfahren zum Betrieb einer Verstärkerschaltung (10) nach einem der vorangehenden Ansprüche, wobei mit der Eingangsschaltung (E) und einer geeigneten Ansteuerung der davon umfassten eingangsseitigen Schaltelemente (Q1, Q2, Q3, Q4) die Betriebsspannung (V_{Bat}) zerhackt wird, wobei an die Primärwicklung (P) des Transformators (TR) die zerhackte Betriebsspannung (V_{Bat}) angelegt wird und die an den Sekundärwicklungen (S1, S2) des Transformators (TR) abgreifbare Zwischenspannung mit der Ausgangsschaltung (A) und einer geeigneten Ansteuerung der ausgangsseitigen Schaltelemente (SW1, SW2, SW3, SW4) ein Zusammensetzen der Zwischenspannung erfolgt und wobei aus der zusammengesetzten Zwischenspannung mit einem der Ausgangsschaltung (A) nachfolgenden Filter (F) als resultierendes Ausgangssignal (V) ein Analogsignal erzeugt wird.

13. Verfahren nach Anspruch 12, wobei das Ausgangssignal (V) auf die zur Erzeugung der Ansteuersignale (QA, QB, QE, QF) zur Ansteuerung der ein- und ausgangsseitigen Schaltelemente (Q1-Q4; SW1-SW4) wirksame Ansteuerschaltung (12) zurückgeführt wird und damit das Ausgangssignal (V) eine Phasenlage der Ansteuersignale (QA, QB, QE, QF) bestimmt.
